# FASCICULE DE BREVET EUROPEEN

(11) **EP 0 709 741 B1**
(45) Date de publication et mention de la délivrance du brevet: **11.08.1999**
(21) Numéro de dépôt: 95410118.4
(22) Date de dépôt: 12.10.1995
(51) Int. Cl.: G03F 7/20, H01J 9/02

(54) **Procédé de photolithogravure de motifs circulaires denses**
Photolithographisches Verfahren zur Herstellung von kreisförmigen Strukturen mit hoher Dichte
Photolithographic process for circular dense patterns

(30) Priorité: 24.10.1994 FR 9412925
(43) Date de publication de la demande: 01.05.1996
(73) Titulaire: COMMISSARIAT A L'ENERGIE ATOMIQUE, 75752 Paris Cédex 15 (FR)
(72) Inventeur: Clerc, Jean-Frédéric, F-38120 Saint-Egreve (FR); Randet, Denis, F-38240 Meylan (FR)
(74) Mandataire: de Beaumont, Michel

(56) Documents cités:
- AT-A- 360 050
- DE-A- 3 821 268
- GB-A- 2 253 925
- US-A- 4 668 080
- PATENT ABSTRACTS OF JAPAN vol. 7 no. 30 (P-173) [1175] ,5 Février 1983 & JP-A-57 181549 (MASTAKE SATOU) 9 Novembre 1982,
- PATENT ABSTRACTS OF JAPAN vol. 7 no. 75 (P-187) ,29 Mars 1983 & JP-A-58 004148 (SATOU MASATAKE)

## Description

La présente invention concerne un procédé de photolithogravure de motifs circulaires. Elle s'applique plus particulièrement à un procédé de photolithogravure de motifs circulaires de faible diamètre dans une couche à graver devant présenter une forte densité de motifs.

Classiquement, la photolithogravure de motifs circulaires consiste à déposer une couche de produit photosensible couramment appelé résine sur la couche à graver, à insoler cette couche de résine par l'intermédiaire d'un masque, et à graver. Cette technique n'est plus applicable ou devient excessivement coûteuse quand on veut réaliser des motifs de très faible diamètre à haute densité sur des couches de surface importante.

De tels problèmes se rencontrent par exemple dans la réalisation de membranes finement perforées, dans la réalisation d'affichage à cristaux liquides, ou autres.

On détaillera plus particulièrement, à titre d'exemple, l'application d'un procédé de photolithogravure pour la réalisation de micropointes d'une cathode d'un écran plat de visualisation.

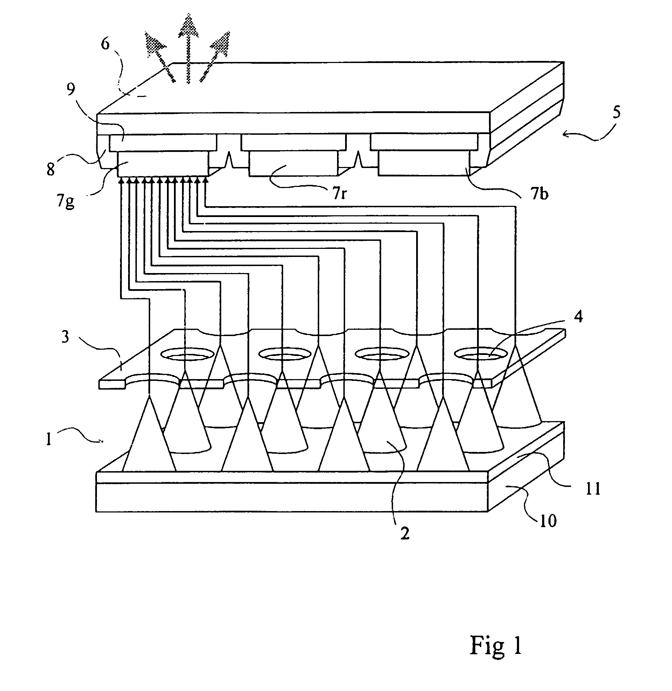

La figure 1 représente la structure d'un écran plat à micropointes. Un tel écran à micropointes est essentiellement constitué d'une cathode 1 à micropointes 2 et d'une grille 3 pourvue de trous 4 correspondant aux emplacements des micropointes 2. La cathode 1 est placée en regard d'une anode cathodoluminescente 5 dont un substrat de verre 6 constitue la surface d'écran.

Le principe de fonctionnement et le détail de la constitution d'un exemple d'écran à micropointes sont décrits dans le brevet européen EP-A-0 316 214 du Commissariat à l'Energie Atomique.

La cathode 1 est organisée en colonnes et est constituée, sur un substrat de verre 10, de conducteurs de cathode organisés en mailles à partir d'une couche conductrice. Les micropointes 2 sont réalisées sur une couche résistive 11 déposée sur les conducteurs de cathode et sont disposées à l'intérieur des mailles définies par les conducteurs de cathode. La figure 1 représentant partiellement l'intérieur d'une maille, les conducteurs de cathode n'apparaissent pas sur cette figure. La cathode 1 est associée à la grille 3 qui est elle organisée en lignes. L'intersection, d'une ligne de la grille 3 et d'une colonne de la cathode 1, définit un pixel.

Ce dispositif utilise le champ électrique créé entre l'anode 5 et la cathode 1 pour que des électrons soient extraits des micropointes 2 vers une couche cathodoluminescente 7 de l'anode 5, sous la commande de la grille 3. Dans le cas d'un écran couleur, tel que représenté à la figure 1, l'anode 5 est pourvue de bandes alternées d'éléments luminophores 7, correspondant chacune à une couleur (Bleu, Rouge, Vert). Les bandes sont séparées les unes des autres par un isolant 8. Les éléments luminophores 7 sont déposés sur des électrodes 9, constituées de bandes correspondantes d'une couche conductrice transparente telle que de l'oxyde d'indium et d'étain (ITO). Les ensembles de bandes bleues, rouges, vertes sont alternativement polarisés par rapport à la cathode 1 pour que les électrons extraits des micropointes 2 d'un pixel de la cathode/grille soient alternativement dirigés vers les éléments luminophores 7 en vis à vis de chacune des couleurs.

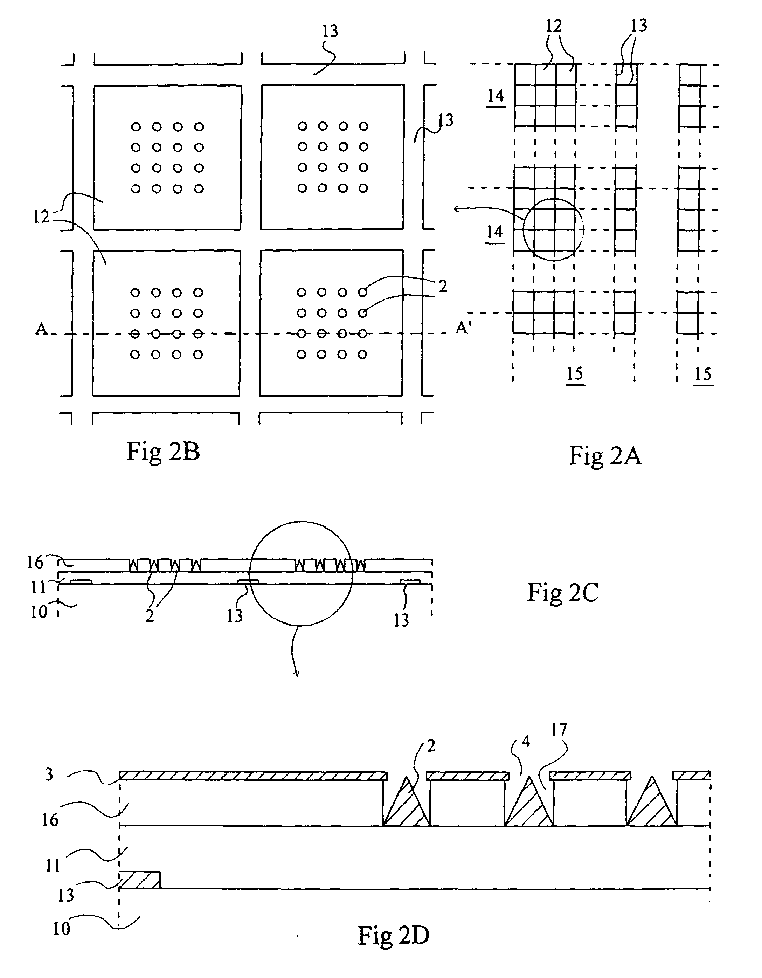

Les figures 2A à 2D illustrent un exemple d'une constitution de ce type, les figures 2B et 2D étant respectivement des agrandissements de parties des figures 2A et 2C. Plusieurs micropointes 2, par exemple seize, sont disposées dans chaque maille 12 définie par les conducteurs de cathode 13 (figure 2B). L'intersection d'une ligne 14 de la grille 3 et d'une colonne 15 de la cathode 1 correspond ici, par exemple, à soixante-quatre mailles 12 d'un pixel de cathode (figure 2A).

La cathode 1 est généralement constituée de couches déposées successivement sur le substrat de verre 10. Les figures 2C et 2D représentent partiellement une vue en coupe selon la ligne A-A' de la figure 2B. Une couche conductrice 13, par exemple constituée de niobium, est déposée sur le substrat 10. Cette couche 13 est gravée selon un motif de colonnes 15, chaque colonne comportant des mailles 12 entourées de conducteurs de cathode 13. Une couche résistive 11 est ensuite déposée sur ces conducteurs de cathode 13. Cette couche résistive 11, constituée par exemple de silicium amorphe dopé au phosphore, a pour objet de protéger chaque micropointe 2 contre un excès de courant à l'amorçage d'une micropointe 2. L'apposition d'une telle couche résistive 11 vise à homogénéiser l'émission électronique des micropointes 2 d'un pixel de la cathode 1 et à accroître ainsi sa durée de vie. Une couche isolante 16, par exemple d'oxyde de silicium (SiO₂), est déposée sur la couche résistive 11 pour isoler les conducteurs de cathode 13 de la grille 3 (figure 2D). La grille 3 est formée d'une couche conductrice, par exemple de niobium. Des trous 4 et des puits 17 sont respectivement pratiqués dans les couches 3 et 16 pour recevoir les micropointes 2 qui sont par exemple en molybdène.

La réalisation de la cathode 1 à micropointes 2 requiert donc la formation de trous circulaires 4 et de puits cylindriques 17 dans la grille 3 et dans la couche isolante 16. La formation de ces trous 4 et puits 17 fait appel à un procédé de photolithogravure de motifs circulaires. On applique sur la couche de grille 3 une résine photosensible qui fait l'objet d'une insolation après avoir été partiellement masquée pour déterminer la position des trous 4 et donc des micropointes 2.

Classiquement le diamètre d'un puits 17 a une valeur comprise entre 1 et 2 µm, le pas étant de l'ordre de 2 à 10 µm, et le nombre de micropointes est de plusieurs milliers par pixel d'écran.

En raison de ces contraintes dimensionnelles, les procédés de photolithogravure existants limitent la surface des écrans plats pouvant être réalisés.

Le document GB-A-2 253 925 décrit un autre procédé de photolithogravure de motifs circulaires de faible diamètre dans une couche à graver, qui consiste à insoler oette couche à travers des sphères opaques de mercure, lesdites sphères étant placées sur la couche à graver.

La présente invention a pour objet de pallier les inconvénients des techniques actuelles en proposant un procédé de photolithogravure de motifs circulaires qui permette d'obtenir un diamètre régulier des motifs circulaires et une densité régulière de motifs, et ce indépendamment de la surface de la couche à graver.

Pour atteindre cet objet, la présente invention prévoit un procédé de photolithogravure de motifs circulaires identiques denses et de faible diamètre dans une couche, consistant à déposer une couche de résine sur ladite couche et à insoler cette couche de résine, procédé qui consiste à réaliser, préalablement à une étape d'insolation, un dépôt de microbilles calibrées, opaques pour le rayonnement d'insolation, sur la surface de la couche de résine.

Selon un mode de réalisation de l'invention, les microbilles présentent un diamètre donné d'une valeur comprise entre 1 et 5 µm.

Selon un mode de réalisation de l'invention, l'étape d'insolation est réalisée au moyen d'un faisceau quasi-parallèle de rayonnement ultraviolet.

Selon un mode de réalisation de l'invention, l'étape de dépôt des microbilles consiste à pulvériser, sur la couche de résine, un solvant à base d'alcool auquel ont été préalablement mélangées les microbilles.

Selon un mode de réalisation de l'invention, l'étape de dépôt des microbilles consiste à noyer la couche de résine dans un bain contenant des microbilles en suspension, et à laisser les microbilles se déposer sur la couche de résine par gravité.

Selon un mode de réalisation de l'invention, l'étape d'insolation est effectuée au moyen d'un insolateur à faisceau quasi-parallèle à un axe donné ; et la couche de résine est disposée avec un angle prédéterminé par rapport à cet axe autour duquel elle est entraînée en rotation.

Selon un mode de réalisation de l'invention, le procédé consiste à effectuer, préalablement à l'étape de dépôt des microbilles, une étape de pré-insolation de la couche de résine, par masquage de surfaces prédéterminées dans lesquelles les motifs circulaires doivent être gravés.

L'invention prévoit également l'application d'un tel procédé de photolithogravure de motifs circulaires, à la fabrication d'une cathode d'un écran à micropointes, la couche de résine étant appliquée sur un empilement de couches comprenant successivement à partir d'un substrat, une couche de conducteurs de cathode organisés en colonnes munies de mailles, une couche résistive, une couche d'isolement et une couche conductrice de grille ; les motifs circulaires définissant dans les couches de grille et d'isolement, des emplacements de trous et de puits de réception des micropointes.

Selon un mode de réalisation de l'invention, une étape de pré-insolation de la couche de résine est effectuée, préalablement à l'étape de dépôt des microbilles, par masquage de surfaces au plus équivalentes aux mailles définies par les conducteurs de cathode.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
les figures 1 et 2A à 2D, décrites précédemment, sont destinées à exposer l'état de la technique et le problème posé dans une application particulière de la présente invention ;
les figures 3A à 3D représentent schématiquement une couche à graver à différentes étapes du procédé de photolithogravure selon un mode de réalisation de l'invention ;
les figures 4A et 4B représentent une variante de mise en oeuvre de l'étape d'insolation du procédé objet de l'invention ;
la figure 5 représente un exemple de mise en oeuvre de l'étape de dépôt des microbilles du procédé selon l'invention ;
la figure 6 représente une variante de mise en oeuvre de l'étape de dépôt des microbilles du procédé selon l'invention ; et
les figures 7A à 7C représentent un exemple d'application du procédé selon l'invention à une cathode à micropointes.

Les représentations des figures ne sont pas à l'échelle pour des raisons de clarté.

Selon un aspect de la présente invention, on a pu se rendre compte que, lorsque l'on a recours à un procédé de photolithogravure de motifs circulaires du type auquel s'applique l'invention, il est important que les motifs présentent des dimensions régulières. Par contre, il est fréquent qu'il ne soit pas nécessaire que ces motifs soient équidistants les uns des autres, mais qu'il suffise que la densité moyenne de motifs soit constante.

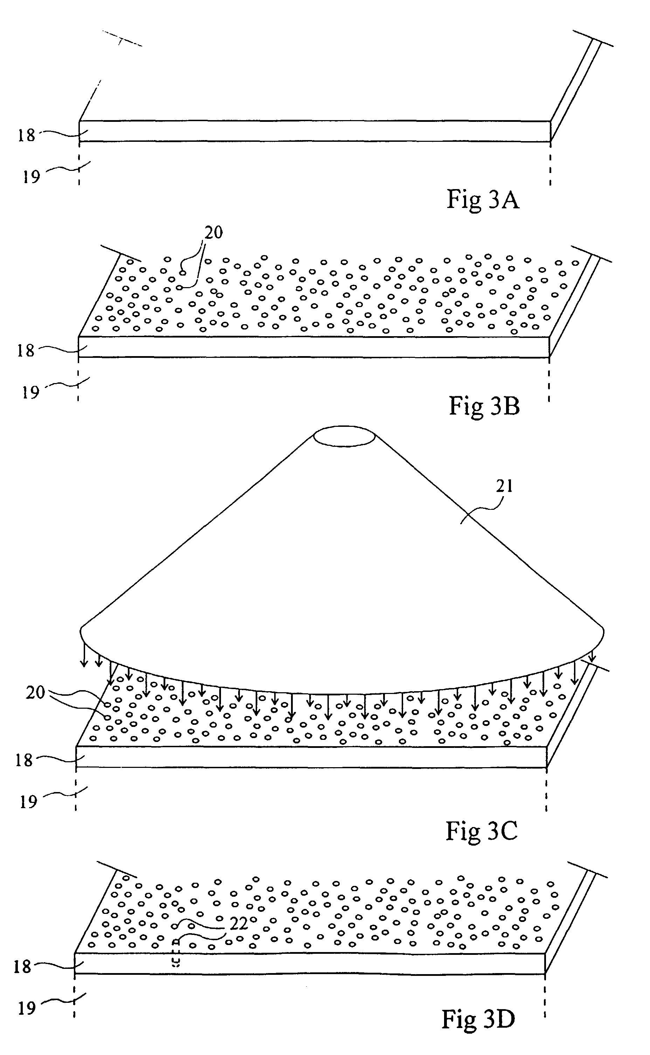

Dans une première étape d'un exemple de mise en oeuvre du procédé selon l'invention, comme le montre la figure 3A, une couche de résine photosensible 18 de type négatif est appliquée sur une couche 19 à graver.

Dans une deuxième étape (figure 3B), des microbilles 20 sont déposées sur la couche de résine 18. Ces microbilles 20 sont par exemple des microbilles de verre ou de plastique. Elles sont opaques au rayonnement d'insolation pour obtenir un effet de masquage maximal des zones sur lesquelles elles sont déposées. La répartition des microbilles 20 sur la couche de résine 18 est aléatoire. L'invention s'applique donc plus particulièrement à un procédé de photolithogravure de motifs circulaires pour lesquels on recherche essentiellement une régularité dans le diamètre des motifs et dans la densité des motifs dans toute la couche.

On utilise donc pour effectuer le masquage des emplacements des motifs dans la couche de résine 18, des microbilles 20 de faible diamètre, régulier d'une microbille à une autre, par exemple à une valeur donnée comprise entre 1 et 2 µm à mieux que 10% près.

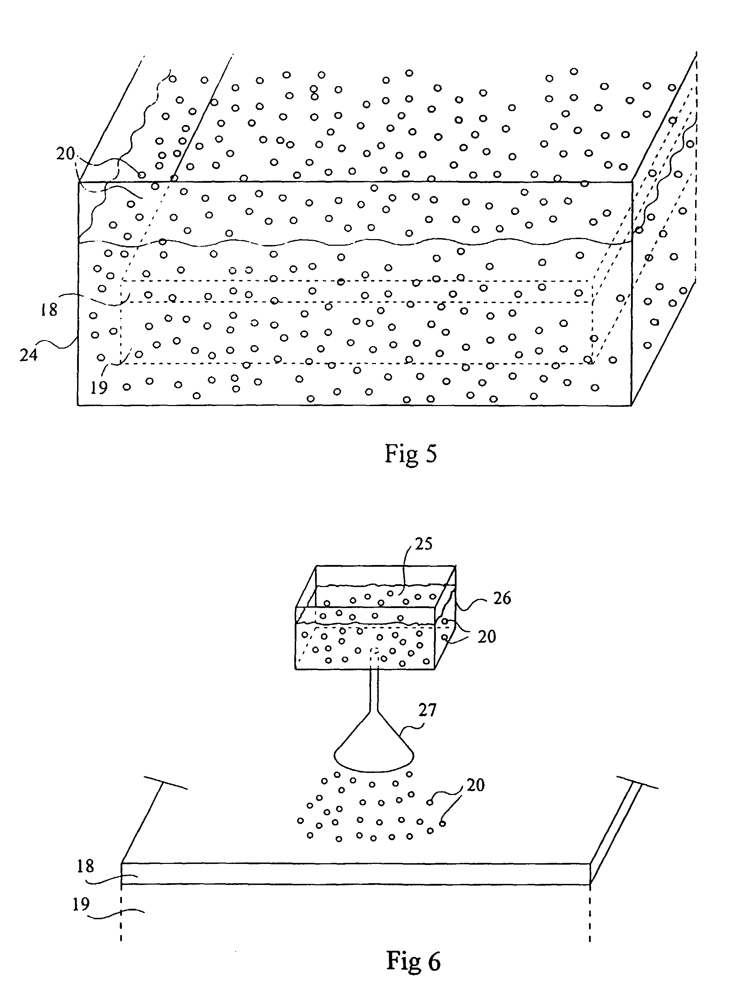

Comme on vient de le voir, la répartition des microbilles 20 est aléatoire. Il est cependant important de s'assurer que la densité des microbilles 20 déposées sur la couche 18 est suffisante et régulière. Pour ce faire on peut utiliser, selon l'invention, plusieurs méthodes de dépôt des microbilles 20, qui seront décrites plus loin en relation avec les figures 5 et 6.

Une fois que les microbilles 20 ont été déposées sur la couche de résine 18, cette couche de résine 18 est insolée au moyen d'un insolateur 21 à lumière quasi-parallèle au cours d'une troisième étape (figure 3C). La longueur d'onde du rayonnement de l'insolateur 21 est choisie en fonction de la résine utilisée et de la précision visée, par exemple dans le domaine des ultraviolets. Les microbilles 20 sont ensuite évacuées de la couche de résine 18 au cours d'une quatrième étape (non représentée).

Dans une cinquième étape (figure 3D), on développe la résine par la mise en oeuvre d'un procédé classique dans des conditions compatibles avec le type de résine utilisé. Des motifs circulaires 22 sont ainsi formés dans la couche de résine 18 aux emplacements des microbilles 20, et sont ensuite utilisés pour graver des motifs correspondants dans la couche 19.

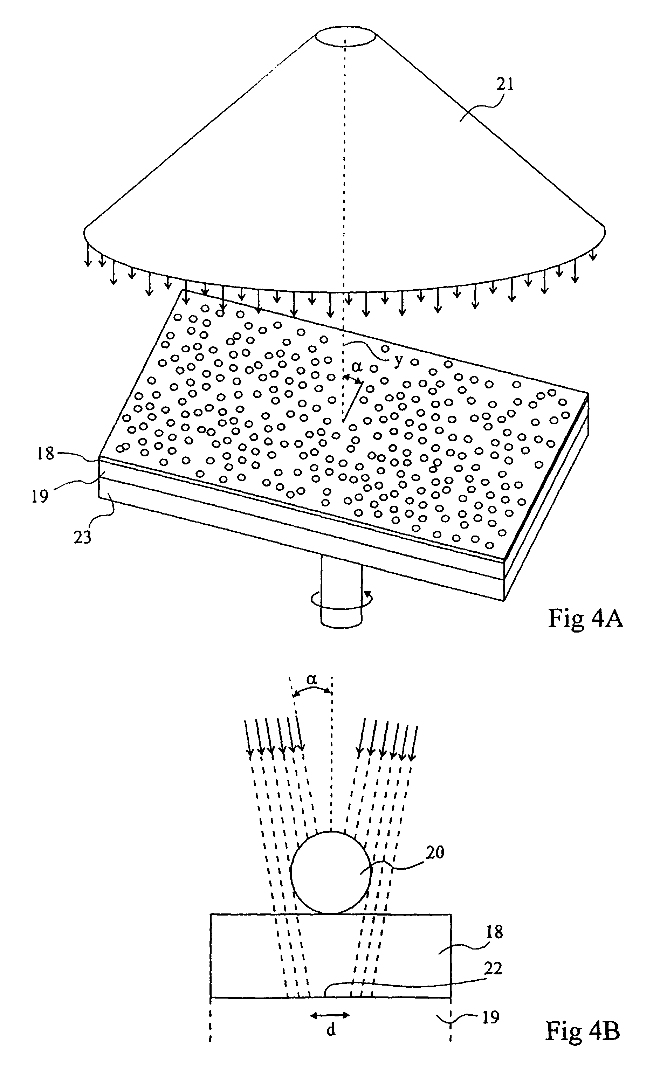

Une variante de l'étape d'insolation (troisième étape) est représentée aux figures 4A et 4B. Cette variante consiste à insoler la couche de résine 18, toujours au moyen d'un insolateur 21 à lumière quasi-parallèle, mais en inclinant la couche 18 par rapport à l'axe Y du faisceau, et en la faisant tourner autour de cet axe Y. Pour ce faire, on pose par exemple la couche à graver 19, revêtue de la couche de résine 18 sur laquelle ont été déposées les microbilles 20, sur un support rotatif 23 incliné d'un angle donné *α* par rapport à l'axe Y du faisceau.

Ainsi, comme le montre la figure 4B, le diamètre d effectivement insolé à l'aplomb de chaque microbille 20 est inférieur au diamètre des microbilles 20. On obtient ainsi des motifs 22 de diamètre d inférieur au diamètre des microbilles 20. Le rapport entre le diamètre des microbilles 20 et le diamètre d des motifs 22 obtenus dépend de l'angle d'inclinaison *α* du support 23 par rapport à l'axe Y du faisceau quasi-parallèle de rayonnement de l'insolateur 21. Cette variante améliore encore la résolution obtenue par la mise en oeuvre du procédé selon l'invention. On peut en effet utiliser des microbilles 20 de taille plus importante qui présenteront une meilleure uniformité entre elles. On peut par exemple réaliser des motifs 22 de diamètre 2 µm au moyen de microbilles 20 présentant un diamètre de 5 µm.

On décrira par la suite, en relation avec les figures 5 et 6, des méthodes pouvant être utilisées pour déposer les microbilles 20, de manière aléatoire et en densité élevée, sur la couche de résine 18.

Une première méthode (figure 5) consiste à immerger la couche à graver 19, revêtue de la couche de résine 18, dans un bain 24 contenant des microbilles 20 en suspension. La densité des microbilles 20 dans le bain est fixée en fonction de la densité de motifs 22 souhaitée. Le dépôt des microbilles 20 s'effectue par décantation, les microbilles utilisées étant dans ce cas en verre. Il est de plus possible d'effectuer l'étape d'insolation à travers le bain 24 dès que les microbilles 20 ont décanté, ce qui accélère l'exécution du procédé. L'évacuation des microbilles 20, après insolation, s'effectue ici simplement en retirant la couche à graver 19 et son éventuel support du bain 24.

Une seconde méthode (figure 6) consiste à pulvériser, sur la couche de résine 18, un mélange de solvant 25 et de microbilles 20 contenu dans un réservoir 26. Le solvant 25 est à base d'alcool, ce qui permet son évaporation pendant la pulvérisation. La distribution des microbilles 20 sur la couche de résine 18 présente une bonne homogénéité, la densité de microbilles 20 étant fixée par la durée de la pulvérisation réalisée. Ici, les microbilles 20 tiennent sur la couche de résine 18 par effet électrostatique, résultant de charges acquises lors de leur traversée de l'air entre une buse 27 du pulvérisateur et la couche de résine 18. L'évacuation des microbilles 20 après insolation peut être effectuée par soufflage ou tout autre moyen. Un avantage de cette technique est qu'il se crée entre les microbilles, du fait de leur charge, une force répulsive qui tend à améliorer la régularité de leur répartition.

Une autre variante (non représentée) de l'invention consiste à noyer des microbilles 20 dans un matériau visqueux, par exemple du polyvinylalcool. On couvre la couche de résine 18 d'une couche de ce matériau par exemple par raclage ou par sérigraphie sans motif. On sèche ensuite le polyvinylalcool puis on insole de la manière décrite plus haut. Par la suite, le polyvinylalcool est dissous, par exemple dans de l'eau, et les microbilles 20 sont évacuées en même temps.

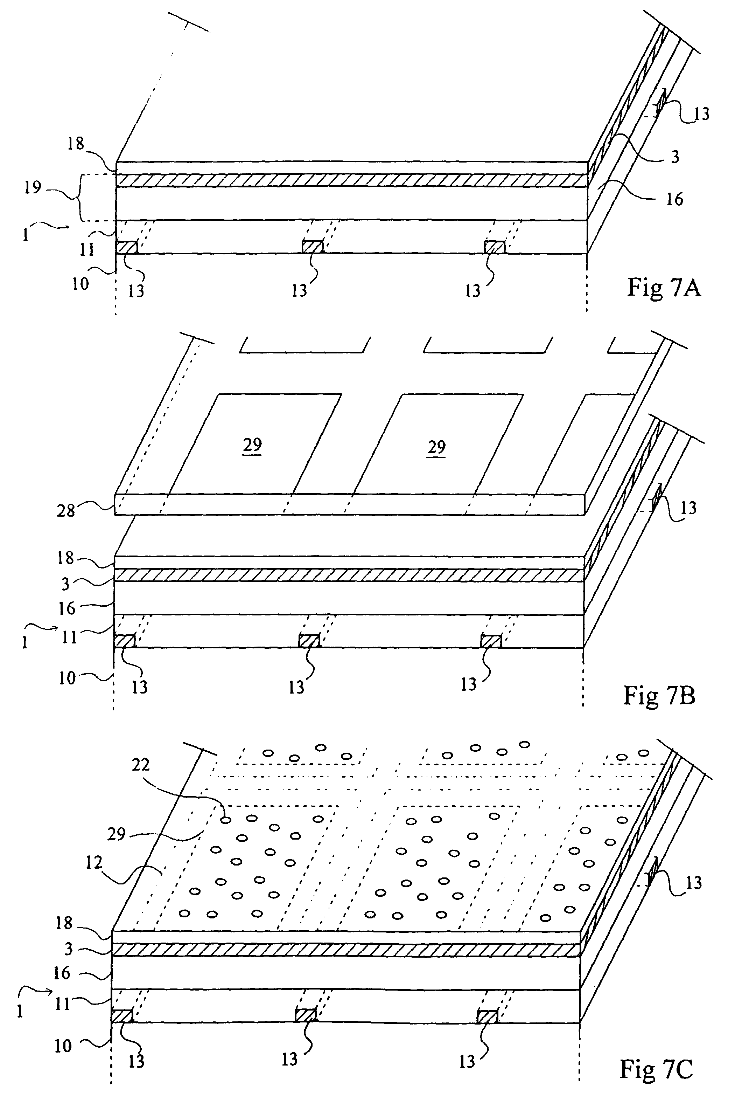

Les figures 7A à 7C illustrent un exemple d'application du procédé décrit ci-dessus à la réalisation de motifs circulaires définissant les emplacements des micropointes dans une cathode à micropointes d'un écran plat de visualisation.

La figure 7A représente l'empilement de couches que comporte une cathode 1 à micropointes préalablement à la mise en oeuvre du procédé de photolithogravure selon l'invention. Comme cela a déjà été exposé en relation avec les figures 2A à 2D, une couche conductrice, par exemple à base de niobium, est déposée sur un substrat 10. Cette couche conductrice est gravée pour définir des conducteurs de cathode 13. Ces conducteurs 13 sont organisés en colonnes munies de mailles 12, chaque maille 12 définissant une zone de réception de micropointes 2, et chaque colonne présentant une largeur correspondant à celle d'un pixel de l'écran. Une couche résistive 11 est ensuite déposée sur les conducteurs de cathode 13. Puis on dépose une couche isolante 16, par exemple constituée d'oxyde de silicium (SiO₂), qui isole les conducteurs de cathode 13 d'une couche de grille 3, par exemple à base de niobium, qui termine l'empilement.

La couche 19 à graver par la mise en oeuvre du procédé selon l'invention, est ici constituée des deux couches de grille 3 et d'isolement 16 dans lesquelles on souhaite former des trous 4 et puits cylindriques 17 de réception des micropointes 2.

L'utilisation du procédé de photolithogravure selon l'invention est rendue possible par le fait que l'on a pu constater que la qualité d'un écran était liée à la régularité de la densité des micropointes 2 d'un pixel de l'écran à un autre et à la régularité du diamètre des micropointes 2. Par contre, l'écart entre deux micropointes 2 n'a pas d'influence sur la qualité de l'écran pourvu que la densité de micropointes soit élevée. Ainsi, la répartition aléatoire des motifs 22 dans la couche 19 n'a pas de conséquence sur la qualité de l'écran. On a ainsi constaté que l'on obtenait un écran plat de bonne qualité avec un nombre et un diamètre de motifs circulaires 22 dans chaque pixel de l'écran qui sont les mêmes à cinq pour cent près, la densité de motifs 22 d'un pixel étant élevée pour ne pas nuire à la brillance de l'écran. Un dépôt de microbilles calibrées 20 d'un diamètre donné d'une valeur comprise entre 1 et 5 µm avec une tolérance de 10 pour cent pour le diamètre des microbilles 20 permet d'atteindre ce résultat.

Par contre, on préfèrera respecter les espaces entre les groupes de micropointes 2 de deux mailles 12 voisines, c'est-à-dire les intervalles dépourvus de micropointes 2 à l'aplomb des conducteurs de cathode 13 (voir figures 2B à 2D).

Pour ce faire, on met en oeuvre une variante du procédé selon l'invention. Cette variante consiste à réaliser une double insolation de la couche de résine 18 en effectuant une étape de pré-insolation avant l'étape de dépôt des microbilles 20.

Au cours de cette étape intermédiaire (figure 7B), on pré-insole la couche de résine 18 à travers un masque classique 28 d'obturation de surfaces 29 contenues dans les mailles 12 définies par les conducteurs de cathode 13. L'utilisation d'un masque classique 28 est ici satisfaisante dans la mesure où les intervalles entre les groupes de micropointes 2 représentent une distance suffisante (de l'ordre de 10 à 20 µm) pour les résolutions de ce type de masques, les mailles 12 étant dépourvues de micropointes 2 à leur périphérie. De plus, cette distance permet d'accepter une certaine tolérance dans le masque 28. Puis on reprend l'exécution du procédé tel que décrit à l'aide des figures 3B à 3D. Durant la deuxième étape (figure 3B), les microbilles 20 sont déposées par l'une quelconque des méthodes exposées précédemment en relation avec les figures 5 et 6. L'insolation de la troisième étape (figure 3C ou 4A) est alors effectuée. Cette insolation n'est efficace que dans les surfaces 29 qui étaient masquées au cours de l'étape intermédiaire de pré-insolation, soit vers le centre des mailles 12. Ainsi, lors du développement de la résine au moyen d'un procédé classique (figure 7C), on obtient des motifs 22 dans la couche de résine 18 uniquement dans la surface centrale 29 des mailles 12. La mise en oeuvre d'une telle variante permet de positionner les zones de micropointes 2 de la cathode 1 au centre des mailles 12, en limitant la formation des motifs 22 à des surfaces 29 de l'écran qui correspondent à des zones devant recevoir des micropointes 2. Lors de l'étape de pré-insolation, on préfère masquer des surfaces 29 réduites par rapport aux surfaces des mailles 12. Ceci pour préserver une homogénéité du courant circulant dans les micropointes 2 par l'intermédiaire de la couche résistive 11, en évitant que des motifs 22 se forment à la périphérie des mailles 12. A la figure 7C, le tracé des mailles 12, à l'aplomb des conducteurs de cathode 13, a été représenté en traits mixtes, et celui des surfaces pré-insolées 29 a été représenté en pointillés.

Par la suite, la réalisation des trous 4 et puits 17 dans les couches de grille 3 et d'isolement 16 s'effectue de manière classique, comme cela est indiqué dans le document de l'art antérieur cité plus haut.

Bien entendu, la présente invention est susceptible de diverses variantes et modifications qui apparaîtront à l'homme de l'art. En particulier, bien que la présente description ait fait référence à un exemple de mise en oeuvre du procédé pour la réalisation d'une cathode à micropointes, le procédé selon l'invention peut être mis en oeuvre pour la réalisation d'autres éléments pour lesquels on a besoin de motifs circulaires dans un procédé de photolithogravure.

De même, les constituants des différentes couches ont été donnés à titre d'exemple, le procédé selon l'invention s'applique à tout type de couche pourvu que ses constituants soient compatibles avec les étapes du procédé et l'application souhaitée. En particulier, le rayonnement ultraviolet convient pour une résine photosensible classique de type négatif sensible aux ultraviolets. On pourra cependant utiliser d'autres types de rayonnements en fonction de la résine choisie.

## Revendications

1. Procédé de photolithogravure de motifs circulaires (22) identiques, denses et de faible diamètre dans une couche (19), consistant à déposer une couche de résine (18) sur ladite couche (19) et à insoler cette couche de résine (18), caractérisé en ce qu'il consiste à réaliser, préalablement à une étape d'insolation, un dépôt de microbilles calibrées (20), opaques pour le rayonnement d'insolation, sur la surface de la couche de résine (18).

2. Procédé de photolithogravure de motifs circulaires selon la revendication 1, caractérisé en ce que les microbilles (20) sont disposées de façon aléatoire.

3. Procédé de photolithogravure de motifs circulaires selon la revendication 1, caractérisé en ce que les microbilles (20) présentent un diamètre donné d'une valeur comprise entre 1 et 5 µm.

4. Procédé de photolithogravure de motifs circulaires selon l'une quelconque des revendications 1 à 3, caractérisé en ce que l'étape d'insolation est réalisée au moyen d'un faisceau quasi-parallèle de rayonnement ultraviolet.

5. Procédé de photolithogravure de motifs circulaires selon l'une quelconque des revendications 1 à 4, caractérisé en ce que l'étape de dépôt des microbilles (20) consiste à pulvériser, sur la couche de résine (18), un solvant (25) à base d'alcool auquel ont été préalablement mélangées les microbilles (20).

6. Procédé de photolithogravure de motifs circulaires selon l'une quelconque des revendications 1 à 4, caractérisé en ce que l'étape de dépôt des microbilles (20) consiste à noyer la couche de résine (18) dans un bain (24) contenant des microbilles (20) en suspension, et à laisser les microbilles (20) se déposer sur la couche de résine (18) par gravité.

7. Procédé de photolithogravure de motifs circulaires selon l'une quelconque des revendications 1 à 6, caractérisé en ce que l'étape d'insolation est effectuée au moyen d'un insolateur (21) à faisceau quasi-parallèle à un axe donné (Y) ; et en ce que la couche de résine (18) est disposée avec un angle prédéterminé (α) par rapport à cet axe (Y) autour duquel elle est entraînée en rotation.

8. Procédé de photolithogravure de motifs circulaires selon l'une quelconque des revendications 1 à 7, caractérisé en ce qu'il consiste à effectuer, préalablement à l'étape de dépôt des microbilles (20), une étape de pré-insolation de la couche de résine (18), par masquage (28) de surfaces prédéterminées (29) dans lesquelles les motifs circulaires (22) doivent être gravés.

9. Application du procédé de photolithogravure de motifs circulaires selon l'une quelconque des revendications 1 à 8, à la fabrication d'une cathode (1) d'un écran à micropointes (2), caractérisé en ce que la couche de résine (18) est appliquée sur un empilement de couches comprenant successivement à partir d'un substrat (10), une couche de conducteurs de cathode (13) organisés en colonnes (15) munies de mailles (12), une couche résistive (11), une couche d'isolement (16) et une couche conductrice de grille (3) ; et en ce que les motifs circulaires (22) définissent dans les couches de grille (3) et d'isolement (16), des emplacements de trous (4) et de puits (17) de réception des micropointes (2).

10. Application du procédé de photolithogravure de motifs circulaires selon la revendication 9, caractérisée en ce qu'une étape de pré-insolation de la couche de résine (18) est effectuée, préalablement à l'étape de dépôt des microbilles (20), par masquage de surfaces (29) au plus équivalentes aux mailles (12) définies par les conducteurs de cathode (13).

## Patentansprüche

1. Verfahren zur Lichtdruckgravur- bzw.-ätzung gleichartiger kreisförmiger Strukturen mit hoher Dichte und kleinem Durchmesser in einer Schicht (19), wobei das Verfahren die Aufbringung bzw. Abscheidung einer Harzschicht (18) auf der genannten Schicht (19) und eine Belichtung dieser Harzschicht (18) umfaßt,
dadurch **gekennzeichnet,** daß
vor einem Belichtungs-Verfahrensschritt eine Aufbringung bzw. Abscheidung von für die Belichtungsstrahlung undurchlässigen kalibrierten Mikrokugeln (20) erfolgt.

2. Verfahren zur Lichtdruckgravur bzw. -ätzung kreisförmiger Strukturen, nach Anspruch 1, dadurch gekennzeichnet, daß die Mikrokugeln (20) zufallartig unregelmäßig angeordnet sind.

3. Verfahren zur Lichtdruckgravur bzw. -ätzung kreisförmiger Strukturen, nach Anspruch 1, dadurch gekennzeichnet, daß die Mikrokugeln (20) einen gegebenen Durchmesser mit einem Betrag im Bereich zwischen 1 und 5 µm aufweisen.

4. Verfahren zur Lichtdruckgravur bzw. -ätzung kreisförmiger Strukturen, nach einem der Ansprüche 1 bis 3, dadurch gekennzeichnet, daß der Verfahrensschritt der Belichtung mit einem quasiparallelen Strahlungsbündel ausgeführt wird.

5. Verfahren zur Lichtdruckgravur bzw. -ätzung kreisförmiger Strukturen, nach einem der Ansprüche 1 bis 4, dadurch gekennzeichnet, daß der Verfahrensschritt der Aufbringung bzw. Abscheidung der Mikrokugeln (20) darin besteht, daß man auf der Harzschicht (18) ein Lösungsmittel (25) auf alkoholischer Basis aufsprüht, dem zuvor die Mikrokugeln (20) beigemengt wurden.

6. Verfahren zur Lichtdruckgravur bzw. -ätzung kreisförmiger Strukturen, nach einem der Ansprüche 1 bis 4, dadurch gekennzeichnet, daß der Verfahrensschritt der Aufbringung bzw. Abscheidung der Mikrokugeln (20) darin besteht, daß man die Harzschicht (18) in einem Mikrokugeln (20) in Suspension enthaltenden Bad eintaucht und die Mikrokugeln (20) sich unter Schwerkraftwirkung auf der Harzschicht absetzen läßt.

7. Verfahren zur Lichtdruckgravur bzw. -ätzung kreisförmiger Strukturen, nach einem der Ansprüche 1 bis 6, dadurch gekennzeichnet, daß der Belichtungsverfahrensschritt mittels einer Belichtungsvorrichtung (21) mit zu einer gegebenen Achse (Y) quasiparallelem Strahlungsbündel erfolgt, und daß die Harzschicht (18) unter einem vorgegebenem Winkel (α) bezüglich dieser Achse (Y) angeordnet ist und zur Drehung um diese angetrieben wird.

8. Verfahren zur Lichtdruckgravur bzw. -ätzung kreisförmiger Strukturen, nach einem der Ansprüche 1 bis 7, dadurch gekennzeichnet, daß es vor dem Verfahrensschritt der Aufbringung bzw. Abscheidung der Mikrokugeln (20) eine Verfahrensstufe der Vorbelichtung der Harzschicht (18) durch eine Maske (28) vorbestimmmter Oberflächenbereiche (29), in welchen die kreisförmigen Strukturen graviert bzw. geätzt werden sollen, umfaßt.

9. Anwendung des Verfahrens zur Lichtdruckgravur bzw. -ätzung, nach einem der Ansprüche 1 bis 7, auf die Herstellung einer Kathode (1) eines Mikrospitzen- Bild-bzw. Anzeigeschirms (2), dadurch gekennzeichnet, daß die Harzschicht (18) auf einen Schichtstapel aufgebracht wird, welcher ausgehend von einem Substrat (10) in Aufeinanderfolge eine Schicht von Kathodenleitern (13), welche in mit Maschenzellen (12) versehenen Spalten (15) organisiert sind, eine Widerstandsschicht (11), eine Isolierschicht (16) und eine leitende Gitterschicht (3) umfaßt, und daß die kreisförmigen Strukturen (22) in der Gitterschicht (3) und der Isolierschicht (16) Stellen für Löcher (4) und Schächte (17) zur Aufnahme der Mikrospitzen definieren.

10. Anwendung des Verfahrens zur Lichtdruckgravur bzw. -ätzung kreisförmiger Strukturen, nach Anspruch 9, dadurch gekennzeichnet, daß vor der Verfahrensstufe der Aufbringung bzw. Abscheidung der Mikrokugeln (20) eine Verfahrensstufe der Vorbelichtung durch eine Maske (28) von Oberflächenbereichen (29), die maximal den durch die Kathodenleiter (13) definierten Maschenzellen (12) entsprechen, erfolgt.

## Claims

1. A photolithographic method for patterning identical small diameter circles (22) at a high resolution on a layer (19), comprising the step of depositing a resist layer (18) on said layer (19), characterized in that it consists in realizing, prior to an irradiating step, the deposition of calibrated microspheres (20), opaque to the radiation, on the surface of the resist layer (18).

2. Photolithographic method for patterning circles according to claim 1, characterized in that said microspheres (20) are deposited at random.

3. Photolithographic method for patterning circles according to claim 1, characterized in that the microspheres (20) have a predetermined diameter ranging between 1 and 5 µm.

4. Photolithographic method for patterning circles according to any of claims 1 to 3, characterized in that the irradiation step is carried out with a beam of quasi parallel ultraviolet radiation.

5. Photolithographic method for patterning circles according to any of claims 1 to 4, characterized in that the step of depositing microspheres (20) comprises spraying, on the resist layer (18), a alcohol based solvent (25) in which the microspheres (20) have been previously mixed.

6. Photolithographic method for patterning circles according to any of claims 1 to 4, characterized in that the step of depositing microspheres (20) comprises immersing the resist layer (18) in a bath (24) containing a suspension of the microspheres (20), and letting the microspheres (20) deposit on the resist layer (18) by gravity.

7. Photolithographic method for patterning circles according to any of claims 1 to 6, characterized in that the step of irradiating is carried out with a source (21) of a beam substantially parallel to an axis (Y); and the resist layer (18) is placed at a predetermined angle α with respect to this axis (Y) about which it is rotated.

8. Photolithographic method for patterning circles according to any of claims 1 to 7, characterized in that it comprises, previous to the step of depositing microspheres (20), a pre-irradiation step of the resist layer (18), by masking (28) predetermined areas (29) in which the circles (22) should be patterned.

9. Use of the photolithographic method for patterning circles according to any of claims 1 to 8 in the production of a cathode (1) of a microtip screen (2), characterized in that the resist layer (18) is applied on a stack of layers successively comprising on a substrate (10), a layer of cathode conductors (13) organized in columns (15) provided with cells (12), a resistive layer (11), an insulating layer (16), and a grid conducting layer (3), and wherein the circles (22) define on the grid (3) and insulating (16) layers, locations for holes (4) and wells (17) for receiving microtips (2).

10. Use of the photolithographic method for patterning circles according to claim 9, characterized in that a pre-irradiation step of the resist layer (18) is carried out previous to the step of depositing microspheres (20), by masking the areas (29) at most equivalent to the cells (12) defined by the cathode conductors (13).
